# EUROPÄISCHE PATENTANMELDUNG

(11) **EP 3 661 336 A1**
(43) Veröffentlichungstag der Anmeldung: **03.06.2020**
(21) Anmeldenummer: 18209565.3
(22) Anmeldetag: 30.11.2018
(51) Int. Cl.: H05K 1/02, G02B 6/42, H05K 3/32

(54) **SCHUTZVORRICHTUNG**

(71) Anmelder: Siemens Aktiengesellschaft, 80333 München (DE)
(72) Erfinder: Bigl, Thomas, 91074 Herzogenaurach (DE); Oschmann, Philipp, 91058 Erlangen (DE); Hensler, Alexander, 90766 Fürth (DE); Neugebauer, Stephan, 91058 Erlangen (DE); Ochs, Ewgenij, 90765 Fürth (DE); Pfefferlein, Stefan, 90562 Heroldsberg (DE); Wetzel, Ulrich, 91325 Adelsdorf (DE)

(57) **Zusammenfassung**

Die Erfindung betrifft eine Schutzvorrichtung (1) zum Schutz eines Bauelements einer elektronischen Baugruppe gegen unerwünschte Umgebungseinflüsse, mit einem ersten Bauelement (2), einem zweiten Bauelement (3) und einem zu schützenden Bauelement (4), wobei das erste Bauelement (2) an einer ersten Bauelementseite (5) eine erste Faserstruktur (6) aus ersten Fasern (7) und das zweite Bauelement (3) an einer zweiten Bauelementseite (8) eine zweite Faserstruktur (9) aus zweiten Fasern (10) aufweist, wobei die erste Bauelementseite (5) der zweiten Bauelementseite (8) gegenüberliegt, wobei das zu schützende Bauelement (4) mit der ersten Bauelementseite (5) oder mit der zweiten Bauelementseite (8) mechanisch verbunden ist, wobei das erste Bauelement (2) mit dem zweiten Bauelement (3) durch Ineinandergreifen der ersten Fasern (7) mit den zweiten Fasern (10) mechanisch verbunden ist, wobei das zu schützende Bauelement (4) in einem ersten Bereich (11) zwischen dem ersten und dem zweiten Bauelement (2,3) angeordnet ist, wobei das zu schützenden Bauelement (4) in dem ersten Bereich (11) von den ineinandergreifenden ersten und zweiten Fasern (7,10) derart umgeben ist, dass das zu schützende Bauelement (4) vor festen Fremdkörpern (27) aus einem zweiten Bereich (12) mit einem Durchmesser von >= 10pm geschützt ist und wobei der zweite Bereich (12) durch die ineinandergreifenden ersten und zweiten Fasern (7,10) von dem ersten Bereich (11) abgegrenzt ist.

## Beschreibung

Die Erfindung betrifft eine Schutzvorrichtung zum Schutz eines Bauelements einer elektronischen Baugruppe gegen unerwünschte Umgebungseinflüsse, mit einem ersten Bauelement, einem zweiten Bauelement und einem zu schützenden Bauelement, welches in einem Bereich zwischen dem ersten und dem zweiten Bauelement angeordnet ist.

Die meisten Bauelemente von elektronischen Baugruppen in elektrischen Geräten der Industrie sind sowohl während deren bestimmungsgemäßen Betriebs wie auch bei deren Montage während des Herstellungsprozesses der elektronischen Baugruppen oftmals unerwünschten Umgebungseinflüssen ausgesetzt. Dies betrifft nicht nur elektronische Bauelemente, sondern beispielsweise rein optische Bauelemente oder auch elektrische Leiter auf Leiterplatten sowie deren elektrische Anschlüsse (Kurzschlussgefahr durch insbesondere nicht eingehaltene Luft- und Kriechstrecken).

So können die beispielsweise für elektronische Baugruppen verwendeten Bauelemente u.a. beim Einsatz der elektronischen Baugruppen in elektrischen Umrichtern der Antriebstechnik feste Fremdkörper in Form von kleinsten, oft nur im Mikrobereich zu messenden Partikeln, also beispielsweise Staubpartikel, in einem unerwünschten Maße ausgesetzt sein.

Mit Blick auf Probleme, welche mit unerwünschten festen Fremdkörpern beim Herstellungsprozesses von mit Bauelementen bestückten elektronischen Baugruppen auftreten können, sei beispielhaft auf die Montage von optischen bzw. optoelektronischen Bauelementen auf einem Schaltungsträger einer elektronischen Baugruppe verwiesen.

Diese optischen bzw. optoelektronischen Bauelemente sollten derart auf den Schaltungsträger aufgebracht sowie mechanisch und ggf. elektrisch verbunden werden, dass sich möglichst keine Verschmutzungen, also beispielsweise unerwünschte feste Fremdkörper während und nach dem Bestückungsprozess auf den aktiven optischen Flächen niederschlagen. Dies gilt generell auch für die mechanisch und ggf. elektrisch sensiblen Bereiche des optischen bzw. optoelektronischen Bauelements, damit dieses Bauelement, die elektronische Baugruppe, auf der es zum Einsatz kommt, und das elektrische Geräte, dessen Funktionalität von der elektronischen Baugruppe mit dem optischen bzw. optoelektronischen Bauelement abhängt, zuverlässig betreibbar ist.

Für den genannten Herstellungsprozess der elektronischen Baugruppe mit einem optischen bzw. optoelektronischen Bauelementen aber auch für Herstellungsprozesse mit einem anderen Bauelement werden diese Bauelemente meist selektiv mit Klebstoff versehen und auf den Schaltungsträger gefügt, wobei der Klebstoff noch entsprechend ausgehärtet wird. Eine elektrische Anbindung der beispielsweise optoelektronischen Bauelemente an weitere elektrische Komponenten des Schaltungsträgers der elektronischen Baugruppe erfolgt danach meist über Bonddrähte oder andere Kontaktierungsmittel via Löten.

Beim Bestücken, also beim Fügen von optischen bzw. optoelektronischen Bauelementen auf den Schaltungsträger, entstehen demnach unter Verwendung von Klebstoff beim Fügeprozesses sowie unter Verwendung von Lot beim Lötvorgang Verunreinigungen, welche sich z.B. in Form von Flussmittelresten des Lotes, Klebstoffresten bzw. Lösemittelresten auf der aktiven optischen Fläche niederschlagen. So ist insbesondere bei optischen Bauelementen, welche vertikal in Richtung des Schaltungsträgers angeordnet sind, die Wahrscheinlichkeit einer Verunreinigung durch die Nähe der elektrischen Kontaktflächen zu den optisch aktiven Flächen sehr hoch.

Es besteht ferner auch der Nachteil, dass sich prozessbedingt, nach dem Positionieren des optischen bzw. optoelektronischen Bauelements auf dem Schaltungsträger, dessen Lage in unerwünschter Weise verändern kann. Gründe dafür sind beispielsweise, dass diese Lageveränderung durch die Bewegung des Schaltungsträgers in notwendigen Folgeprozessen hervorgerufen wird oder sich die Stabilität der in unmittelbarer Nähe befindlichen Klebeverbindung durch die beim Löten auftretenden Temperaturen zumindest kurzzeitig verschlechtert und bei deren erneutem Erhärten das optische bzw. optoelektronische Bauelement verzogen wird. Dies ist dann in Toleranzbetrachtung für den Einsatz der Bauelemente mit einzubeziehen. Oftmals macht es den Aufwand in der Auswahl der Bauelemente aufwendiger und letztendlich teurer.

Der Erfindung liegt daher die Aufgabe zugrunde, eine Schutzvorrichtung vorzuschlagen, welche ein Bauelement einer elektronischen Baugruppe gegenüber unerwünschten Umgebungseinflüssen beim Herstellungsprozess der elektronischen Baugruppe und/oder für den bestimmungsgemäßen Einsatz des Bauelements mit der elektronischen Baugruppe besser schützt.

Die Aufgabe wird durch eine Schutzvorrichtung mit den in Anspruch 1 angegebenen Merkmalen, durch eine elektronische Baugruppe mit der Schutzvorrichtung nach den in Anspruch 13 angegebenen Merkmalen sowie durch einen elektrischen Umrichter mit der elektronischen Baugruppe nach den in Anspruch 15 angegebenen Merkmalen gelöst.

Für die Lösung der Aufgabe wird eine Schutzvorrichtung zum Schutz eines Bauelements einer elektronischen Baugruppe gegen unerwünschte Umgebungseinflüsse mit einem ersten Bauelement, einem zweiten Bauelement und einem zu schützenden Bauelement vorgeschlagen, wobei das erste Bauelement an einer ersten Bauelementseite eine erste Faserstruktur aus ersten Fasern und das zweite Bauelement an einer zweiten Bauelementseite eine zweite Faserstruktur aus zweiten Fasern aufweist, wobei die erste Bauelementseite der zweiten Bauelementseite gegenüberliegt, wobei das zu schützende Bauelement mit der ersten Bauelementseite oder mit der zweiten Bauelementseite mechanisch verbunden ist, wobei das erste Bauelement mit dem zweiten Bauelement durch Ineinandergreifen der ersten Fasern der ersten Faserstruktur mit den zweiten Fasern der zweiten Faserstruktur mechanisch verbunden ist, wobei das zu schützende Bauelement in einem ersten Bereich zwischen dem ersten und dem zweiten Bauelement angeordnet ist, wobei das zu schützenden Bauelement in dem ersten Bereich von den ineinandergreifenden ersten und zweiten Fasern derart umgeben ist, dass das zu schützende Bauelement vor festen Fremdkörpern aus einem zweiten Bereich mit einem Durchmesser von >= 10pm geschützt ist und wobei der zweite Bereich durch die ineinandergreifenden ersten und zweiten Fasern von dem ersten Bereich abgegrenzt ist.

Durch die ineinandergreifenden ersten Fasern der ersten Faserstruktur mit den zweiten Fasern der zweiten Faserstruktur ist in vorteilhafter Weise eine erste Abgrenzung zwischen dem ersten Bereich mit dem zu schützenden Bauelement und dem zweiten Bereich ausgebildet, welche verhindert, dass feste Fremdkörper >= 10pm, wie beispielsweise gröbere Staubpartikel, aus dem zweiten Bereich in den ersten Bereich eindringen und die Funktionsfähigkeit des zu schützenden Bauelements beeinträchtigen.

Auch ist zumindest ein Spritzschutz des zu schützenden Bauelements des ersten Bereichs gegenüber Flüssigkeiten aus dem zweiten Bereich mittels der ineinandergreifenden ersten Fasern der ersten Faserstruktur mit den zweiten Fasern der zweiten Faserstruktur erzeugbar.

Die mechanische Verbindung der ineinandergreifenden ersten Fasern der ersten Faserstruktur mit den zweiten Fasern der zweiten Faserstruktur ist im Allgemeinen dadurch herstellbar, dass beim Zusammenfügen der ersten und zweiten Fasern an der von der ersten Bauelementseite des ersten Bauelement abgewandten Seite und/oder an der von der zweiten Bauelementseite des zweiten Bauelements abgewandten Seite eine Druckkraft ausgeübt wird, welche die ersten und die zweiten Fasern, ähnlich einem Klettverschluss, ineinander verschlingen. Je nach z.B. ausgeübter Druckkraft oder gewählten Material der Fasern entsteht so beispielsweise eine stoffschlüssig unlösbare Verbindung oder zumindest eine eingeschränkt lösbare Verbindung der ineinandergreifenden ersten Fasern mit den zweiten Fasern.

Insbesondere wenn die erzeugte mechanische Verbindung eine zumindest eingeschränkt lösbare Verbindung ist, einige Fasern der Faserstrukturen werden hier ggf. beim Lösen der Verbindung für eine erneute mechanische Verbindung unbrauchbar, können im Herstellungsprozess des Einbaus des zu schützenden Bauelements in die elektrische Baugruppe Korrekturen der Lage des ersten Bauelements gegenüber dem zweiten Bauelement vorgenommen und somit auch das zu schützende Bauelement an seinem Anbauort auf der elektronischen Baugruppe neu justiert werden.

Ein bevorzugtes Material der ersten und zweiten Fasern ist Metall oder ein Mischmaterial mit einem metallischen Anteil, um eine stabile mechanische Verbindung zu erzeugen. Aber auch Materialien aus Kunststoff oder Gewebematerialien sind für die mechanische Verbindung der ineinandergreifenden ersten Fasern mit den zweiten Fasern geeignet.

Vorteilhafte Ausgestaltungsformen des modularen Umrichters sind in den abhängigen Ansprüchen angegeben.

Bei einer ersten vorteilhaften Ausgestaltungsform der Schutzvorrichtung weist das erste Bauelement an einer ersten Bauelementseite eine dritte Faserstruktur aus dritten Fasern und das zweite Bauelement an einer zweiten Bauelementseite eine vierte Faserstruktur aus vierten Fasern aufweist, ist das erste Bauelement mit dem zweiten Bauelement durch Ineinandergreifen der dritten Fasern der dritten Faserstruktur mit den vierten Fasern der vierten Faserstruktur mechanisch verbunden, ist das zu schützenden Bauelement von den ineinandergreifenden dritten und vierten Fasern, welche die ineinandergreifenden ersten und zweiten Fasern umschließen, derart umgeben, dass das zu schützende Bauelement vor Fremdkörpern mit einem Durchmesser von >= 1µm aus dem zweiten Bereich geschützt ist und ist der zweite Bereich durch die ineinandergreifenden dritten und vierten Fasern, welche die ineinandergreifenden ersten und zweiten Fasern umschließen, zusätzlich von dem ersten Bereich abgegrenzt.

Zusätzlich zu den ineinandergreifenden Fasern der erste Faserstruktur mit den zweiten Fasern der zweiten Faserstruktur ist mit den ineinandergreifenden dritten Fasern der dritten Faserstruktur mit den vierten Fasern der vierten Faserstruktur in vorteilhafter Weise eine zweite Abgrenzung zwischen dem ersten Bereich mit dem zu schützenden Bauelement und dem zweiten Bereich ausgebildet, welche in Kombination mit der ersten Abgrenzung als Vorfilterung verhindert, dass feste Fremdkörper >= 1µm, wie beispielsweise feine Staubpartikel, aus dem zweiten Bereich in den ersten Bereich eindringen und die Funktionsfähigkeit des zu schützenden Bauelements beeinträchtigen.

Damit können die meisten in der Industrie auftretenden unerwünschten festen Fremdkörper, also im Allgemeinen im industriellen Umfeld auftretende feine Staubpartikel, von dem ersten Bereich und somit von dem zu schützenden Bauelement ferngehalten werden.

Auch der Spritzschutz des zu schützenden Bauelements gegenüber Flüssigkeiten aus dem zweiten Bereich ist so weiter verbesserbar.

Die Erzeugung der mechanischen Verbindung der ineinandergreifenden dritten Fasern mit den vierten Fasern, die mögliche Einbaukorrektur des zu schützenden Bauelements und der Einsatz von bevorzugten Materialien für die dritten und vierten Fasern ist analog zu den ineinandergreifenden ersten Fasern und zweiten Fasern zu betrachten.

Bei einer ebenfalls vorteilhaften Ausgestaltungsform der Schutzvorrichtung ist zwischen den ineinandergreifenden ersten und zweiten Fasern und den ineinandergreifenden dritten und vierten Fasern und zwischen dem ersten Bauelement und dem zweiten Bauelement eine Dichtung angeordnet, welche das zu schützende Bauelement im ersten Bereich vollständig vor festen Fremdkörpern und/oder vor Flüssigkeiten aus dem zweiten Bereich schützt.

Durch die in vorteilhafter Weise zwischen den ineinandergreifenden ersten und zweiten Fasern und den ineinandergreifenden dritten und vierten Fasern eingebrachte Dichtung kann der erste Bereich mit dem zu schützende Bauelement vollständig gegenüber festen Fremdkörpern wie auch gegenüber Flüssigkeiten aus dem zweiten Bereich abgegrenzt und somit hermetisch abgeschottet werden.

Denkbar ist auch die Nutzung der Dichtung als Abgrenzung des zu schützenden Bauelements im ersten Bereich gegenüber Gasen aus dem zweiten Bereich.

Bei einer weiteren vorteilhaften Ausgestaltungsform der Schutzvorrichtung ist das erste Bauelement mit dem zweiten Bauelement durch die ineinandergreifenden ersten und zweiten Fasern und, falls vorhanden, durch die ineinandergreifenden dritten und vierten Fasern ohne eine weitere unmittelbare mechanische Verbindung, welche zur Erzeugung mechanischer Stabilität der mechanischen Verbindung der beiden Bauelemente beitragen kann, verbunden.

Durch diese unmittelbare mechanische Verbindung mittels der ineinandergreifenden Fasern kann auf weitere mechanische Verbindungen zur Sicherstellung der mechanischen Stabilität der mechanischen Verbindung der beiden Bauelemente, wie z.B. auf Klebstoffverbindungen oder auf Schraubverbindungen, verzichtet werden.

Bei einer weiteren vorteilhaften Ausgestaltungsform der Schutzvorrichtung weist die Dichtung Material mit hauptsächlich elastisch verformbaren Eigenschaften auf.

Elastisch verformbare Dichtungsmaterialien haben den Vorteil, dass sich die Dichtung den gegeben Raumbedingungen flexibel anpassen kann und diesen Raum, hier ist der Raum zwischen den ineinandergreifenden ersten und zweiten Fasern und den ineinandergreifenden dritten und vierten Fasern gemeint, auch vollständig ausfüllen kann. Dabei haben elastische Materialien den Drang, bei Verformung wieder in ihre Ausgangsform zurückkehren zu wollen, was den Aufbau eines Drucks der Dichtung gegen die Begrenzungen des Raums erhöht und die Abdichtung des ersten Bereichs mit dem zu schützenden Bauelement gegenüber dem zweiten Bereich weiter verbessert.

Bei einer weiteren vorteilhaften Ausgestaltungsform der Schutzvorrichtung sind mittels der ineinandergreifenden ersten und zweiten Fasern und/oder, falls vorhanden, mittels der ineinandergreifenden dritten und vierten Fasern elektrische Verbindung und/oder Kommunikationsverbindungen ausbildbar.

Mittels elektrisch leitfähiger Fasern kann hier elektrische Energie oder können hier elektrische Signale bzw. Kommunikationsdaten zwischen dem ersten und dem zweiten Bauelement aber auch zwischen dem ersten und/oder dem zweiten Bauelement, jeweils mit dem zu schützenden Bauelement, in vorteilhafter Weise übertragen werden.

Bei einer weiteren vorteilhaften Ausgestaltungsform der Schutzvorrichtung ist das erste Bauelement ein elektronisches Bauelement, insbesondere ein optoelektronisches Bauelement, und das zweite Bauelement ein Trägerelement, insbesondere eine Leiterplatte.

Bei einer weiteren vorteilhaften Ausgestaltungsform der Schutzvorrichtung ist das zu schützende Bauelement ein zu schützendes Koppelelement, insbesondere ein zu schützendes optisches Koppelelement, zur Übertragung von Signalen.

Insbesondere optische Koppelelement, welche optische Signale für optoelektronische Bauelemente ein- und auskoppeln, und somit übertragen, müssen besonders vor Verschmutzung geschützt werden. Daher ist die Schutzvorrichtung in besonderer Weise als Schutz vor unerwünschten Umgebungsbedingungen, wie festen Fremdkörpern, Flüssigkeiten oder auch Gasen für das zu schützende optische Koppelelement geeignet. Aber auch andere Koppelelement, wie beispielsweise Koppelelemente für elektromagnetische Wellen, bedürfen des Schutzes vor Verschmutzung, den die Schutzvorrichtung in vorteilhafter Weise herstellt, um die Funktionsfähigkeit der Koppelelemente für den bestimmungsgemäßen Betrieb zu erhalten.

Bei einer weiteren vorteilhaften Ausgestaltungsform der Schutzvorrichtung weisen die ersten und zweiten Fasern und, falls vorhanden, die dritten und vierten Fasern eine Länge in einem mikroskaligen Bereich, insbesondere in einem mikroskaligen Bereich von 1µm bis 50pm, auf.

Mittels der Länge der Fasern in dem angegebenen vorteilhaften mikroskaligen Bereich ist es einerseits möglich, eine jeweils stabile und feste mechanische Verbindung zwischen den ineinandergreifenden ersten mit den zweiten Fasern und, falls vorhanden, den ineinandergreifenden dritten mit den vierten Fasern zu erzeugen aber andererseits auch möglich unerwünschte Umgebungseinflüsse wie beschrieben aus dem zweiten Bereich von dem zu schützenden Bauelement im ersten Bereich fernzuhalten.

Bei einer weiteren vorteilhaften Ausgestaltungsform der Schutzvorrichtung weisen die ersten Fasern Widerhaken und die zweiten Fasern Ösen oder die ersten Fasern Ösen und die zweiten Fasern Widerhaken auf und, falls vorhanden, weisen die dritten Fasern Widerhaken und die vierten Fasern Ösen oder die dritten Fasern Ösen und die vierten Fasern Widerhaken auf.

Mittels der Widerhaken und Ösen an den Fasern ist die Stabilität bzw. die Festigkeit der mechanischen Verbindung der ineinandergreifenden ersten Fasern mit den zweiten Fasern und, falls vorhanden, der ineinandergreifenden dritten Fasern mit den vierten Fasern vorteilhaft verbesserbar, obwohl zu beachten ist, das eine derartige mechanische Verbindungen kaum noch zerstörungsfrei trennbar ist.

Unter Ösen an den Fasern werden in diesem Kontext auch Öffnungen in den Fasern verstanden, welche von Fasern mit Widerhaken bei Herstellung dieser mechanischen Verbindung durchstoßen worden sind. Generell werden Verbindungen, welche Fasern mit Widerhaken und Ösen aufweisen, auch als Klettverschlüsse bezeichnet.

Bei einer weiteren vorteilhaften Ausgestaltungsform der Schutzvorrichtung sind die ersten Fasern auf das erste Bauelement und/oder die zweiten Fasern das zweite Bauelement mittels Materialbeschichtung aufgetragen und/oder, falls vorhanden, sind die dritten Fasern auf das erste Bauelement und/oder die vierten Fasern auf das zweite Bauelement mittels Materialbeschichtung aufgetragen.

Sind diese Fasern durch Materialbeschichtung auf die Bauelemente aufgetragen worden, kann deren Material auch vom jeweiligen Material der entsprechenden Bauelemente abweichen. Dies kann insbesondere auch dann vorteilhaft sein, wenn die ineinandergreifenden ersten Fasern mit den zweiten Fasern und, falls vorhanden, die ineinandergreifenden dritten Fasern mit den vierten Fasern elektrisch leitfähige Eigenschaften besitzen.

Bei einer weiteren vorteilhaften Ausgestaltungsform der Schutzvorrichtung bilden die erste Faserstruktur und die zweite Faserstruktur mit den ineinandergreifenden ersten und zweiten Fasern und, falls vorhanden, die dritte Faserstruktur und die vierte Faserstruktur mit den ineinandergreifenden dritten und vierten Fasern jeweils eine geometrische Figur aus, welche ein Kreis, ein Teilkreis, eine Gerade, ein Polygon oder eine zusammengesetzte geometrische Figur ist, wobei die zusammengesetzte geometrische Figur neben mindestens einem Kreisabschnitt mindestens einen geraden Abschnitt ohne Ecke oder mehrere gerade Abschnitte mit mindestens einer Ecke umfasst.

Mittels der genannten geometrischen Figuren der ersten Faserstruktur und der zweiten Faserstruktur mit den ineinandergreifenden ersten und zweiten Fasern und, falls vorhanden, der dritten Faserstruktur und der vierten Faserstruktur mit den ineinandergreifenden dritten und vierten Fasern ist der erste Bereich mit dem zu schützenden Bauelement in vorteilhafter Weise an die Abmaße des zu schützenden Bauelements anpassbar, so dass ein effektiver Schutz des zu schützenden Bauelements vor Umgebungseinflüssen aus dem zweiten Bereich erzielbar ist.

Für die Lösung der Aufgabe wird ebenfalls eine elektronische Baugruppe mit einer erfindungsgemäßen Schutzvorrichtung vorgeschlagen, wobei in einem Trägerelement ein Wellenleiter eingebettet ist, welcher dazu vorgesehen ist, ein Signal über ein zu schützendes Koppelelement von und/oder zu einem elektronischen Bauelement zu übertragen.

Mittels dem in das Trägerelement eingebetteten Wellenleiter ist es möglich, beispielsweise elektromagnetische Wellen von dem zweiten Bereich in den ersten Bereich zu dem zu schützenden Koppelelement (dann ein elektromagnetisches Koppelelement) der elektronischen Baugruppe (dann eine Baugruppe beispielsweise zur Verarbeitung bzw. Erzeugung von elektromagnetischen Wellen) zu übertragen, wobei der erste Bereich von dem zweiten Bereich durch die Schutzvorrichtung abgegrenzt und das zu schützenden Koppelelement gegenüber unerwünschten Umgebungseinflüssen, wie festen Fremdkörpern, Flüssigkeiten oder ggf. auch Gasen geschützt ist.

Bei einer vorteilhaften Ausgestaltungsform der elektronischen Baugruppe ist der Wellenleiter ein Lichtwellenleiter, das zu schützende Koppelelement ein zu schützendes optisches Koppelelement, das elektronische Bauelement ein optoelektronisches Bauelement und das Signal ein optisches Signal.

Für die Lösung der Aufgabe wird ferner ein elektrischer Umrichter zum Betrieb einer elektrischen Maschine an einem elektrischen Netz mit einer erfindungsgemäßen elektronischen Baugruppe vorgeschlagen, wobei über den Wellenleiter, das zu schützende Koppelelement und das elektronische Bauelement ein Signal für eine und/oder von einer Steuerung des elektrischen Umrichters übertragbar ist und wobei das Signal mittels einer Kommunikationsverbindung mit oder ohne Signalwandlung zwischen dem elektronischen Bauelement und der Steuerung übertragbar ist.

Die elektronische Baugruppe mit der Schutzvorrichtung für das zu schützende Koppelelement und dem elektronischen Bauelement ist in vorteilhafter Weise dazu ausgebildet, der Steuerung des elektrischen Umrichters für den Betrieb der elektrischen Maschine am elektrischen Netz Signale via der Kommunikationsverbindung zu übertragen, wobei das zu schützende Koppelelement durch die Schutzvorrichtung vor unerwünschten Umgebungseinflüssen, wie festen Fremdkörpern, Flüssigkeiten oder ggf. auch Gasen geschützt ist. Diese unerwünschten Umgebungseinflüssen können beim beschriebenen Einsatz des Umrichters insbesondere in industriellen Anlagen entstehen und dürfen die Zuverlässigkeit des elektrischen Umrichters, dessen elektronischer Baugruppe und des auf der elektronischen Baugruppe angeordneten und zu schützenden Bauelements nicht gefährden.
- FIG 1: eine schematische Schnittdarstellung mit ersten Fasern einer ersten Faserstruktur auf einer ersten Bauelementseite eines ersten Bauelements,
- FIG 2: eine schematische Schnittdarstellung mit ersten Fasern einer ersten Faserstruktur auf einer ersten Bauelementseite eines ersten Bauelements nach FIG 1, ineinandergreifend mit zweiten Fasern einer zweiten Faserstruktur auf einer zweiten Bauelementseite eines zweiten Bauelements,
- FIG 3: eine schematische Schnittdarstellung einer erfindungsgemäßen Schutzvorrichtung mit ineinandergreifenden ersten Fasern einer ersten Bauelementseite eines ersten Bauelements mit zweiten Fasern einer zweiten Bauelementseite eines zweiten Bauelements, welche ein zu schützendes Bauelement vor festen Fremdkörpern schützend umgeben,
- FIG 4: eine schematische Darstellung einer Draufsicht auf die erfindungsgemäße Schutzvorrichtung nach FIG 3,
- FIG 5: eine schematische Schnittdarstellung einer Erweiterung einer Schutzvorrichtung nach FIG 3 mit ineinandergreifenden dritten Fasern der ersten Bauelementseite des ersten Bauelements mit vierten Fasern der zweiten Bauelementseite des zweiten Bauelements, welche das zu schützende Bauelement mit den ineinandergreifenden ersten Fasern der ersten Bauelementseite des ersten Bauelements mit den zweiten Fasern der zweiten Bauelementseite des zweiten Bauelements gemeinsam vor festen Fremdkörpern schützend umgeben,
- FIG 6: eine schematische Darstellung einer Draufsicht auf die Schutzvorrichtung nach FIG 5,
- FIG 7: eine schematische Darstellung einer elektronischen Baugruppe mit der Draufsicht auf eine Schutzvorrichtung nach FIG 4 und
- FIG 8: eine schematische Darstellung eines elektrischen Umrichters mit einer elektrischen Baugruppe nach FIG 7.

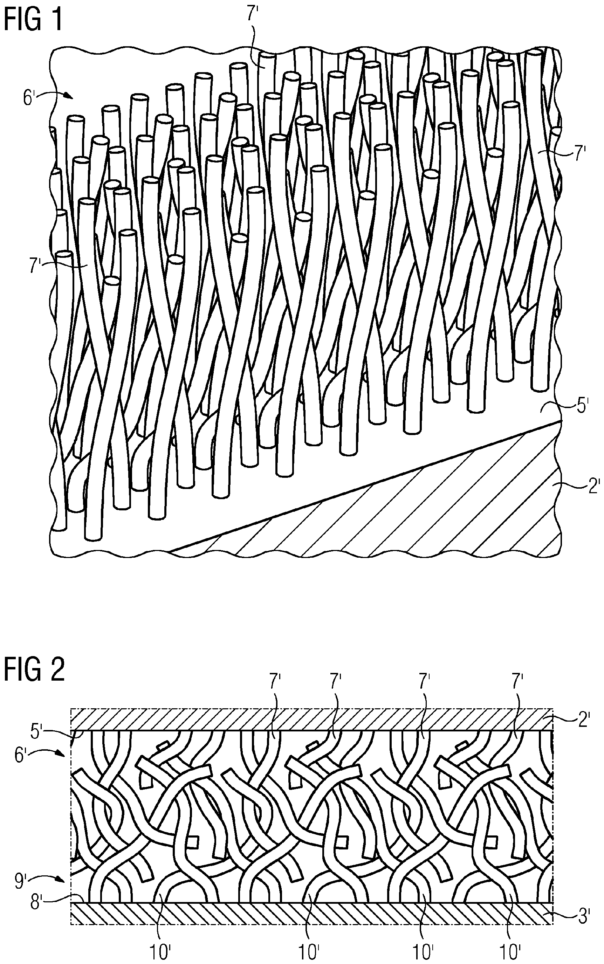

Die FIG 1 zeigt eine schematische Schnittdarstellung einer ersten Faserstruktur 6' auf einer ersten Bauelementseite 5' eines ersten Bauelements 2'. Die Faserstruktur 6' weist dabei erste Fasern 7' auf, welche im Wesentlichen senkrecht von der ersten Bauelementseite 5' des ersten Bauelements 2' abstehen. Die schematische Darstellung der FIG 1 ist dabei stark vergrößert, da hier die ersten Fasern 7' der ersten Faserstruktur 6' im mikroskaligen Bereich ausgebildet sind.

Mit der FIG 2 wird eine schematische Schnittdarstellung mit ersten Fasern 7' der ersten Faserstruktur 6' auf der ersten Bauelementseite 5' des ersten Bauelements 2' nach FIG 1 gezeigt, wobei die ersten Fasern 7' mit zweiten Fasern 10' einer zweiten Faserstruktur 9' ineinandergreifen, und die zweiten Fasern 10' auf einer zweiten Bauelementseite 8' eines zweiten Bauelements 3' angeordnet sind. Damit ist eine stabile und feste mechanische Verbindung des ersten Bauelements 2' mit dem zweiten Bauelement 3' hergestellt.

Insbesondere alle im folgenden beschriebenen Figuren, welche Fasern und Faserstrukturen abbilden, sind bezüglich zumindest dieser Fasern und Faserstrukturen in ihrer schematischen Darstellung stark vergrößert, da die Fasern der Faserstrukturen in der Realität im mikroskaligen Bereich ausgebildet sind.

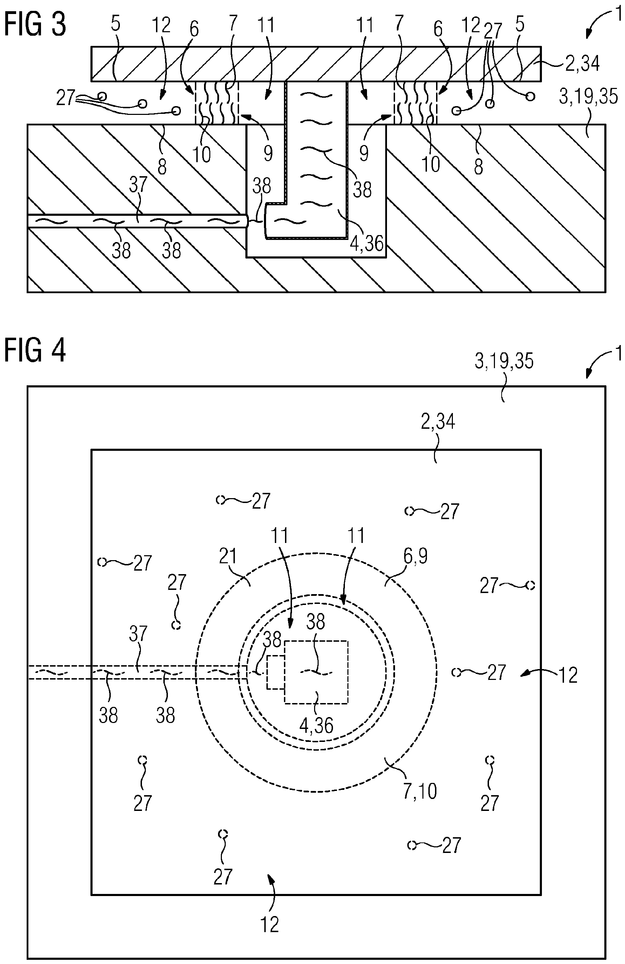

Die FIG 3 zeigt eine schematische Schnittdarstellung einer erfindungsgemäßen Schutzvorrichtung 1 mit ineinandergreifenden ersten Fasern 7 einer ersten Bauelementseite 8 eines ersten Bauelements 2, hier eines elektronischen Bauelements 34, mit zweiten Fasern 10 einer zweiten Bauelementseite 8 eines zweiten Bauelements 3, hier eines Trägerelements 19 in Form einer Leiterplatte 35, wobei die ineinandergreifenden ersten und zweiten Fasern 7, 10 der Faserstrukturen 6,9 ein zu schützendes Bauelement 4, hier ein zu schützendes Koppelelement 36, vor festen Fremdkörpern 27 schützend umgeben.

Ein erster Bereich 11 mit dem zu schützenden Bauelement 4, also dem zu schützenden Koppelelement 36, zwischen dem ersten Bauelement 2, also dem elektronischen Bauelement 34, und dem zweiten Bauelement 3, also dem Trägerelements 19 in Form der Leiterplatte 35, ist von einem zweiten Bereich 12 mittels der ineinandergreifenden ersten Fasern 7 mit den zweiten Fasern 10 abgegrenzt und schützt somit das zu schützende Bauelement 4, also das zu schützende Koppelelement 36, vor den unerwünschten Umgebungseinflüssen, wie den festen Fremdkörpern 27.

Mittels eines Wellenleiters 37 kann ein Signal 38, beispielsweise ein elektromagnetisches Signal, in den ersten Bereich 11 zu dem zu schützenden Bauelement 4, also dem zu schützenden Koppelelement 36, übertragen und an das erste Bauelement 2, also das elektronische Bauelement 34, geleitet werden.

In FIG 4 wird eine schematische Darstellung der Draufsicht auf die erfindungsgemäße Schutzvorrichtung 1 nach FIG 3 gezeigt. Hier ist zu sehen, dass die erste Faserstruktur 6 und die zweite Faserstruktur 9 einen Kreis 21 als geometrische Figur ausbilden und das zu schützende Bauelement 4, hier das zu schützende Koppelelement 36, vollumfänglich umschließen.

Die ersten und zweiten Fasern 7, 10 sind im Gegensatz zur FIG 3 in FIG 4 nur schwer darstellbar und wurden lediglich zu den entsprechenden Faserstrukturen 6,9 verortet.

Diese Darstellung des Kreises 21 ist, obwohl FIG 3 inhaltlich das Gleiche zeigt, mittels der in FIG 3 gewählten Schnittdarstellung nicht darstellbar.

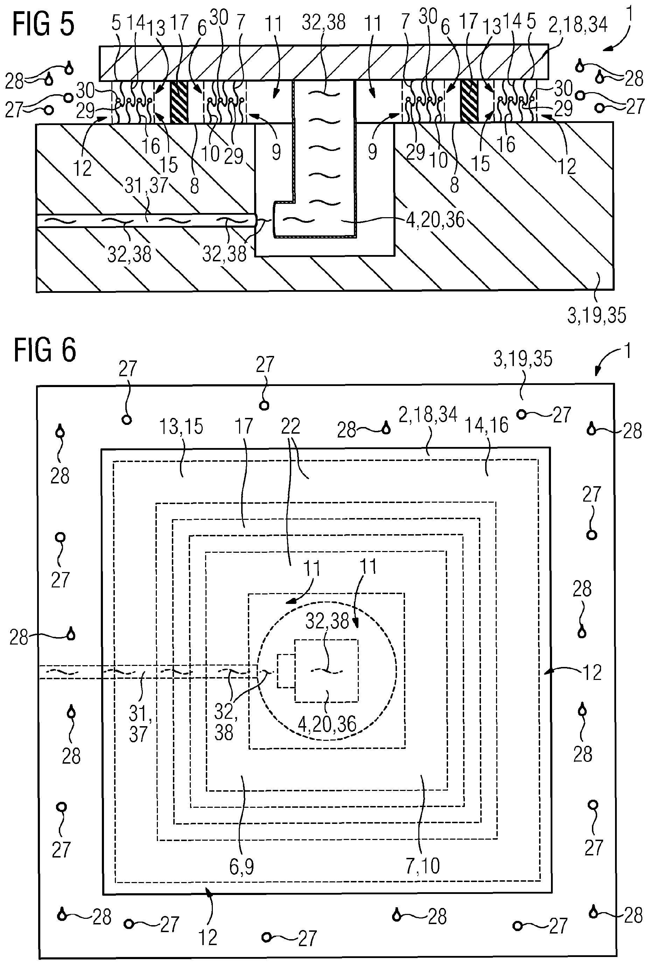

Eine schematische Schnittdarstellung einer Schutzvorrichtung 1 in FIG 5 zeigt eine Erweiterung der Schutzvorrichtung 1 nach FIG 3.

Zusätzlich zur Darstellung der Schutzvorrichtung 1 nach FIG 3 wird bei einer Schutzvorrichtung 1 in FIG 5 mittels ineinandergreifender dritter Fasern 14 eines ersten Bauelements 2, hier eines elektronischen Bauelements 34 in Form eines optoelektronischen Bauelements 18, mit vierten Fasern 16 eines zweiten Bauelements 3, hier eines Trägerelements 19 in Form einer Leiterplatte 35, ein zu schützendes Bauelement 4 eines ersten Bereichs 11, hier ein zu schützendes Koppelelement 36 in Form eines optischen Koppelelements 20, gemeinsam mit ineinandergreifenden ersten Fasern 7 des ersten Bauelements 2 mit zweiten Fasern 10 des zweiten Bauelements 3 vor festen Fremdkörpern 27 und vor Flüssigkeiten 28 aus einem zweiten Bereich 12 schützend umgeben.

Zwischen den ineinandergreifenden ersten Fasern 7 der ersten Faserstruktur 6 mit den zweiten Fasern 7 zweiten Faserstruktur 9 und den ineinandergreifenden dritten Fasern 14 der dritten Faserstruktur 13 und den vierten Fasern 16 der vierten Faserstruktur 15 ist eine Dichtung 17 angeordnet, welche unmittelbar zwischen dem ersten Bauelement 2 und dem zweiten Bauelement 3 eingebracht ist.

Die ersten Fasern 7 der ersten Faserstruktur 6 an der ersten Bauelementseite 5 des ersten Bauelements 2 weisen Widerhaken 29 auf, welche mit Ösen 30 der zweiten Fasern 7 der zweiten Faserstruktur 9 an der zweiten Bauelementseite 8 des zweiten Bauelements 2 mechanisch verbunden sind.

Die dritten Fasern 14 der dritten Faserstruktur 13 an der ersten Bauelementseite 5 des ersten Bauelements 2 weisen ebenfalls Widerhaken 29 auf, welche mit Ösen 30 der vierten Fasern 16 der vierten Faserstruktur 15 an der zweiten Bauelementseite 8 des zweiten Bauelements 2 mechanisch verbunden sind.

Mittels eines Wellenleiters 37 kann ein Signal 38, hier ein optisches Signal, in den ersten Bereich 11 mit dem zu schützenden Bauelement 4, also dem zu schützenden Koppelelement 36 in Form des optischen Koppelelements 20, übertragen und an das erste Bauelement 2, also das elektronische Bauelement 34 in Form des optoelektronischen Bauelements 18, geleitet werden.

In FIG 6 wird eine schematische Darstellung der Draufsicht auf die Schutzvorrichtung 1 nach FIG 5 gezeigt. Hier ist zu sehen, dass sowohl ersten Faserstruktur 6 und die zweite Faserstruktur 9 wie auch die dritte Faserstruktur 13 und die vierte Faserstruktur 15 jeweils ein Polygon 22 als geometrische Figur ausbilden und das zu schützende Bauelement 4, hier das zu schützendes Koppelelement 36, jeweils vollumfänglich umschließen.

Zwischen der ersten und zweiten Faserstruktur 6,9 und der dritten und vierten Faserstruktur 13, 15 ist eine Dichtung 17 angeordnet, welche als geometrische Form ein Polygon ausbildet.

Die ersten und zweiten Fasern 7, 10 und die dritten und vierten Fasern 14,16 sind im Gegensatz zur FIG 5 in FIG 6 nur schwer darstellbar und wurden lediglich zu den entsprechenden Faserstrukturen 6,9 sowie Faserstrukturen 13,15 verortet.

Die Darstellung der Polygone 22 ist, obwohl FIG 5 inhaltlich das Gleiche zeigt, mittels der in FIG 5 gewählten Schnittdarstellung nicht darstellbar.

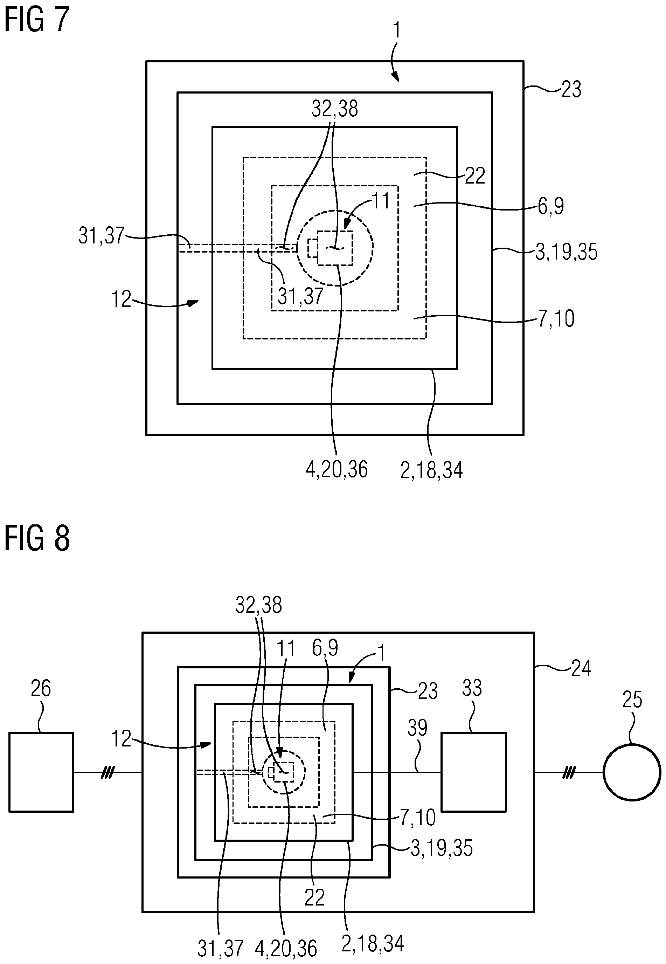

Die FIG 7 zeigt eine schematische Darstellung einer elektronischen Baugruppe 23 mit der Draufsicht auf eine Schutzvorrichtung 1 nach FIG 4.

Über einen Wellenleiter 37, hier ein Lichtwellenleiter 31, wird ein Signal 38, hier ein optisches Signal 32, via dem zu schützenden Bauelement 4, hier ein zu schützendes Koppelelement 36 in Form eines zu schützenden optischen Koppelelements 20, an ein erstes Bauelement 2, hier ein elektronisches Bauelement 34 in Form eines optoelektronischen Bauelements 18, geleitet.

Mit der FIG 8 wird eine schematische Darstellung eines elektrischen Umrichters 24 mit einer elektrischen Baugruppe 23 nach FIG 7 aufgezeigt.

Der elektrische Umrichter 24 betreibt über ein dreiphasiges Drehstromsystem eine elektrische Maschine 25, wobei er über ein weiteres dreiphasiges Drehstromnetz elektrischer Energie aus einem elektrischen Netz 26 bezieht.

Wie in FIG 7 wird in FIG 8 über einen Wellenleiter 37, hier ein Lichtwellenleiter 31, ein Signal 38, hier ein optisches Signal 32, via dem zu schützenden Bauelement 4, hier ein zu schützendes Koppelelement 36 in Form eines zu schützenden optischen Koppelelements 20, an ein erstes Bauelement 2, hier ein elektronisches Bauelement 34 in Form eines optoelektronischen Bauelements 18, geleitet.

Mittels einer Kommunikationsverbindung 39 ist das Signal 38, also das optische Signal 32, mit oder ohne Signalwandlung zwischen dem elektronischen Bauelement 18, also dem elektronischen Bauelement 34 in Form des optoelektronischen Bauelements 18, und einer Steuerung 33 des elektrischen Umrichters 24 übertragbar.

## Patentansprüche

1. Schutzvorrichtung (1) zum Schutz eines Bauelements einer elektronischen Baugruppe gegen unerwünschte Umgebungseinflüsse, mit einem ersten Bauelement (2), einem zweiten Bauelement (3) und einem zu schützenden Bauelement (4), wobei
- das erste Bauelement (2) an einer ersten Bauelementseite (5) eine erste Faserstruktur (6) aus ersten Fasern (7) und das zweite Bauelement (3) an einer zweiten Bauelementseite (8) eine zweite Faserstruktur (9) aus zweiten Fasern (10) aufweist,
- die erste Bauelementseite (5) der zweiten Bauelementseite (8) gegenüberliegt,
- das zu schützende Bauelement (4) mit der ersten Bauelementseite (5) oder mit der zweiten Bauelementseite (8) mechanisch verbunden ist,
- das erste Bauelement (2) mit dem zweiten Bauelement (3) durch Ineinandergreifen der ersten Fasern (7) der erste Faserstruktur (6) mit den zweiten Fasern (10) der zweiten Faserstruktur (9) mechanisch verbunden ist,
- das zu schützende Bauelement (4) in einem ersten Bereich (11) zwischen dem ersten und dem zweiten Bauelement (2,3) angeordnet ist,
- das zu schützenden Bauelement (4) in dem ersten Bereich (11) von den ineinandergreifenden ersten und zweiten Fasern (7,10) derart umgeben ist, dass das zu schützende Bauelement (4) vor festen Fremdkörpern (27) aus einem zweiten Bereich (12) mit einem Durchmesser von >= 10pm geschützt ist und
- der zweite Bereich (12) durch die ineinandergreifenden ersten und zweiten Fasern (7,10) von dem ersten Bereich (11) abgegrenzt ist.

2. Schutzvorrichtung (1) nach Anspruch 1, wobei
- das erste Bauelement (2) an einer ersten Bauelementseite (5) eine dritte Faserstruktur (13) aus dritten Fasern (14) und das zweite Bauelement (3) an einer zweiten Bauelementseite (8) eine vierte Faserstruktur (15) aus vierten Fasern (16) aufweist,
- das erste Bauelement (2) mit dem zweiten Bauelement (3) durch Ineinandergreifen der dritten Fasern (14) der dritten Faserstruktur (13) mit den vierten Fasern (16) der vierten Faserstruktur (15) mechanisch verbunden ist,
- das zu schützenden Bauelement (4) von den ineinandergreifenden dritten und vierten Fasern (14, 16), welche die ineinandergreifenden ersten und zweiten Fasern (7,10) umschließen, derart umgeben ist, dass das zu schützende Bauelement (4) vor festen Fremdkörpern (27) mit einem Durchmesser von >= 1µm aus dem zweiten Bereich (12) geschützt ist und
- der zweite Bereich (12) durch die ineinandergreifenden dritten und vierten Fasern (14, 16), welche die ineinandergreifenden ersten und zweiten Fasern (7,10) umschließen, zusätzlich von dem ersten Bereich (11) abgegrenzt ist.

3. Schutzvorrichtung (1) nach Anspruch 2, wobei zwischen den ineinandergreifenden ersten und zweiten Fasern (7,10) und den ineinandergreifenden dritten und vierten Fasern (14, 16) und zwischen dem ersten Bauelement (2) und dem zweiten Bauelement (2) eine Dichtung (17) angeordnet ist, welche das zu schützende Bauelement (4) im ersten Bereich (11) vollständig vor festen Fremdkörpern (27) und/oder vor Flüssigkeiten (28) aus dem zweiten Bereich (12) schützt.

4. Schutzvorrichtung (1) nach Anspruch 3, wobei das erste Bauelement (2) mit dem zweiten Bauelement (3) durch die ineinandergreifenden ersten und zweiten Fasern (7,10) und, falls vorhanden, durch die ineinandergreifenden dritten und vierten Fasern (14, 16) ohne eine weitere unmittelbare mechanische Verbindung, welche zur Erzeugung mechanischer Stabilität der mechanischen Verbindung der beiden Bauelemente (2,3) beitragen kann, verbunden ist.

5. Schutzvorrichtung (1) nach Anspruch 3 oder 4, wobei die Dichtung (17) Material mit hauptsächlich elastisch verformbaren Eigenschaften aufweist.

6. Schutzvorrichtung (1) nach einem der vorhergehenden Ansprüche, wobei mittels der ineinandergreifenden ersten und zweiten Fasern (7,10) und/oder, falls vorhanden, mittels der ineinandergreifenden dritten und vierten Fasern (14, 16) elektrische Verbindung und/oder Kommunikationsverbindungen ausbildbar sind.

7. Schutzvorrichtung (1) nach einem der vorhergehenden Ansprüche, wobei das erste Bauelement (2) ein elektronisches Bauelement (34), insbesondere ein optoelektronisches Bauelement (18), und das zweite Bauelement (3) ein Trägerelement (19), insbesondere eine Leiterplatte (35), ist.

8. Schutzvorrichtung (1) nach einem der vorhergehenden Ansprüche, wobei das zu schützende Bauelement (4) ein zu schützendes Koppelelement (36), insbesondere ein zu schützendes optisches Koppelelement (20), zur Übertragung von Signalen (38) ist.

9. Schutzvorrichtung (1) nach einem der vorhergehenden Ansprüche, wobei die ersten und zweiten Fasern (7,10) und, falls vorhanden, die dritten und vierten Fasern (14, 16) eine Länge in einem mikroskaligen Bereich, insbesondere in einem mikroskaligen Bereich von 1µm bis 50pm, aufweisen.

10. Schutzvorrichtung (1) nach einem der vorhergehenden Ansprüche, wobei die ersten Fasern (7) Widerhaken (29) und die zweiten Fasern (10) Ösen (30) oder die ersten Fasern (7) Ösen (30) und die zweiten Fasern (10) Widerhaken (29) aufweisen und, falls vorhanden, die dritten Fasern (14) Widerhaken (29) und die vierten Fasern (16) Ösen (30) oder die dritten Fasern (14) Ösen (30) und die vierten Fasern (16) Widerhaken (29) aufweisen.

11. Schutzvorrichtung (1) nach einem der vorhergehenden Ansprüche, wobei die ersten Fasern (7) auf das erste Bauelement (2) und/oder die zweiten Fasern (10) das zweite Bauelement (3) mittels Materialbeschichtung aufgetragen sind und/oder, falls vorhanden, die dritten Fasern (14) auf das erste Bauelement (2) und/oder die vierten Fasern (16) auf das zweite Bauelement (3) mittels Materialbeschichtung aufgetragen sind.

12. Schutzvorrichtung (1) nach einem der vorhergehenden Ansprüche, wobei die erste Faserstruktur (6) und die zweite Faserstruktur (9) mit den ineinandergreifenden ersten und zweiten Fasern (7,10) und, falls vorhanden, die dritte Faserstruktur (13) und die vierte Faserstruktur (15) mit den ineinandergreifenden dritten und vierten Fasern (14, 16) jeweils eine geometrische Figur ausbilden, welche ein Kreis (21), ein Teilkreis, eine Gerade, ein Polygon (22) oder eine zusammengesetzte geometrische Figur ist, wobei die zusammengesetzte geometrische Figur neben mindesten einem Kreisabschnitt mindestens einen geraden Abschnitt ohne Ecke oder mehrere gerade Abschnitte mit mindestens einer Ecke umfasst.

13. Elektronische Baugruppe (23) mit einer Schutzvorrichtung (1) nach einem der Ansprüche 1 bis 12, wobei in einem Trägerelement (19) ein Wellenleiter (37) eingebettet ist, welcher dazu vorgesehen ist, ein Signal (38) über ein zu schützendes Koppelelement (36) von und/oder zu einem elektronischen Bauelement (34) zu übertragen.

14. Elektronische Baugruppe (23) nach Anspruch 13, wobei der Wellenleiter (37) ein Lichtwellenleiter (31) ist, das zu schützende Koppelelement (36) ein zu schützendes optisches Koppelelement (20) ist, das elektronische Bauelement (34) ein optoelektronisches Bauelement (18) ist und das Signal (38) ein optisches Signal (32) ist.

15. Elektrischer Umrichter (24) zum Betrieb einer elektrischen Maschine (25) an einem elektrischen Netz (26) mit einer elektronischen Baugruppe (23) nach Anspruch 14, wobei über den Wellenleiter (37), das zu schützende Koppelelement (36) und das elektronische Bauelement (18) ein Signal (38) für eine und/oder von einer Steuerung (33) des elektrischen Umrichters (24) übertragbar ist und wobei das Signal (38) mittels einer Kommunikationsverbindung (39) mit oder ohne Signalwandlung zwischen dem elektronischen Bauelement (18) und der Steuerung (33) übertragbar ist.
